(19) 

Europäisches
Patentamt

European
Patent Office

Office européen
des brevets

(11) **EP 4 644 044 A1**

(12) **EUROPEAN PATENT APPLICATION**
published in accordance with Art. 153(4) EPC

(43) Date of publication:
**05.11.2025 Bulletin 2025/45**

(21) Application number: **23911538.9**

(22) Date of filing: **01.12.2023**

(51) International Patent Classification (IPC):
**B24B 37/013** *(2012.01)*    **B24B 49/10** *(2006.01)*
**G05B 23/02** *(2006.01)*    **H01L 21/304** *(2006.01)*

(52) Cooperative Patent Classification (CPC):
**B24B 37/013; B24B 49/10; G05B 23/02;
H01L 21/304**

(86) International application number:
**PCT/JP2023/043096**

(87) International publication number:
**WO 2024/142757 (04.07.2024 Gazette 2024/27)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **27.12.2022 JP 2022210291**

(71) Applicant: **EBARA CORPORATION**
**Ota-ku,**
**Tokyo 144-8510 (JP)**

(72) Inventor: **ISHII, Yu**
**Tokyo 144-8510 (JP)**

(74) Representative: **Pritzlaff, Stefanie Lydia**
**Wagner & Geyer Partnerschaft mbB**
**Patent- und Rechtsanwälte**
**Gewürzmühlstraße 5**
**80538 München (DE)**

(54) **POLISHING METHOD, POLISHING DEVICE AND RECORDING MEDIUM**

(57)    The present invention relates to a polishing method, a polishing apparatus, and a recording medium. The polishing method includes inputting a measured output waveform and an estimated detection time into a model constructed by a machine learning algorithm, and outputting a waveform processing recipe, having waveform processing parameters for determining a simulated detection time that minimizes a difference from the estimated detection time, from the model.

*FIG. 4*

START

DETERMINE ESTIMATED DETECTION TIME — S101

MEASURE OUTPUT WAVEFORM — S102

INPUT OUTPUT WAVEFORM AND
ESTIMATED DETECTION TIME INTO MODEL — S103

OUTPUT WAVEFORM PROCESSING RECIPE — S104

END

Processed by Luminess, 75001 PARIS (FR)

## Description

### Technical Field

The present invention relates to a polishing method, a polishing apparatus, and a recording medium.

### Background Art

Chemical mechanical polishing (CMP) is known as a technique in a manufacturing process of semiconductor devices. A polishing apparatus for performing the CMP includes a polishing table that supports a polishing pad and a polishing head that holds a wafer.
When the wafer is polished using such a polishing apparatus, the wafer is held by the polishing head and pressed against a polishing surface of the polishing pad with a predetermined pressure. At this time, the polishing table and the polishing head are moved relative to each other to bring the wafer into sliding contact with the polishing surface, thereby polishing the surface of the wafer. The wafer is an example of a substrate.

### Citation List

### Patent Literature

Patent document 1: Japanese laid-open patent publication No. 2021-065990

### Summary of Invention

### Technical Problem

The substrate such as the wafer has a layered structure made of different materials such as semiconductors, conductors, and insulators. A frictional force acting between the substrate and the polishing pad varies depending on a material of a surface to be polished of the substrate. Therefore, a change in frictional force caused by a change in the material of the surface to be polished of the substrate is detected, and a polishing end point is determined based on a point in time when the frictional force changes.
The change in frictional force can be detected as a change in output of a driving device that drives a polishing mechanism (e.g., the polishing table, the polishing head, a swing arm of the polishing head, etc.) of the polishing apparatus. For example, when the driving device that rotates the polishing table is an electric motor, the change in frictional force can be detected as a change in current flowing through the electric motor.
However, a waveform showing the change in the output of the driving device contains noise components, so that in order to reliably determine the change in the output of the driving device, it is necessary to adjust the waveform processing parameters (i.e., the waveform processing conditions) to remove the noise components.
In this manner, a waveform processing recipe is created by adjusting the waveform processing parameters. The polishing end point of the substrate is determined based on the created waveform processing recipe. Therefore, in order to accurately determine the polishing end point of the substrate, it is necessary to create an optimal waveform processing recipe. However, the waveform processing parameters are adjusted based on an experience of an operator, and creating the optimal waveform processing recipe takes a lot of time and effort.
Therefore, the present invention provides a polishing method, a polishing apparatus, and a recording medium that are capable of creating an optimal waveform processing recipe.

### Solution to Problem

In an embodiment, there is provided a polishing method comprising: determining an estimated detection time based on a polishing end point time from a start of polishing to a polishing end point of a substrate; measuring an output waveform of a driving device of a polishing mechanism during polishing of the substrate; inputting the measured output waveform and the estimated detection time into a model constructed by a machine learning algorithm; and outputting a waveform processing recipe from the model, the waveform processing recipe having waveform processing parameters for determining a simulated detection time that minimizes a difference from the estimated detection time.
In an embodiment, the simulated detection time is calculated by comparing it with the estimated detection time based on the following formula:

[Formula 1]

$$\sum_{i=1}^{n} (sdti - edti)^2/n$$

where, edti: estimated detection time for the i-th substrate
sdti: simulated detection time for the i-th substrate
n: number of polished substrates.

In an embodiment, comprising: acquiring polishing information data including an output value of the driving device by polishing a new substrate of the same type as the substrate; and correcting the polishing end point time by adjusting the simulated detection time based on the polishing information data.

In an embodiment, comprising correcting the polishing end point time by adding a predetermined additional polishing time to the simulated detection time.

In an embodiment, the simulated detection time is calculated by applying at least one of the waveform processing parameters used for waveform processing of the output waveform to the measured output waveform.

In an embodiment, the waveform processing parameters include a parameter for identifying peaks and non-peaks included in the output waveform.

In an embodiment, in constructing the model, an explanatory variable of a learning data is given as the measured output waveform, and a target variable of the learning data is given as a numerical value representing a deviation of a simulated detection time calculated by removing a noise component contained in the output waveform from the estimated detection time.

In an embodiment, there is provided a polishing apparatus comprising: a polishing table configured to support a polishing pad; a polishing head configured to press a substrate against a polishing surface of the polishing pad to polish the substrate; a polishing-head swing arm coupled to the polishing head; and a computer having a storage device and a processing device, and the processing device is configured to: apply waveform processing parameters stored in the storage device to a plurality of output waveforms of a driving device being at least one of the polishing table, the polishing head, and the polishing-head swing arm, measured during polishing of the substrate, to calculate a plurality of simulated detection times; and compare an estimated detection time based on a polishing end point time from a start of polishing to a polishing end point of the substrate with the simulated detection times to create a waveform processing recipe having waveform processing parameters for determining a simulated detection time that minimizes a difference from the estimated detection time.

In an embodiment, the processing device is configured to correct the polishing end point time by adjusting the simulated detection time based on polishing information data including an output value of the driving device, the polishing information data being acquired by polishing a new substrate of the same type as the substrate.

In an embodiment, the processing device is configured to correct the polishing end point time by adding a predetermined additional polishing time to the simulated detection time.

In an embodiment, the storage device stores a model constructed by a machine learning algorithm, and the processing device is configured to: input the output waveform of the driving device and the estimated detection time into the model; and execute a calculation to output a waveform processing recipe from the model, the waveform processing recipe having waveform processing parameters for determining a simulated detection time that minimizes a difference from the estimated detection time.

In an embodiment, there is provided a computer-readable recording medium storing a program that causes a computer to execute: a step of calculating a plurality of simulated detection times by applying waveform processing parameters to a plurality of output waveforms of a driving device of a polishing mechanism measured during polishing of a substrate; and a step of creating a waveform processing recipe having waveform processing parameters for determining a simulated detection time that minimizes a difference from an estimated detection time, by comparing the estimated detection time based on a polishing end point time from a start of polishing to a polishing end point of the substrate, with the simulated detection times.

In an embodiment, the program causes the computer to execute: a step of inputting the output waveform of the driving device and the estimated detection time into an input layer of a model consisting of a neural network having the input layer, a plurality of intermediate layers, and an output layer; and a step of outputting a waveform processing recipe from the output layer, the waveform processing recipe having waveform processing parameters for determining a simulated detection time that minimizes a difference from the estimated detection time by executing calculations according to an algorithm of a multilayer perceptron constituting the neural network.

**Advantageous Effects of Invention**

According to the present invention, it is possible to create a waveform processing recipe that can accurately determine a polishing end point of a substrate in a short period of time.

**Brief Description of Drawings**

[FIG. 1] FIG. 1 is a schematic view showing one embodiment of a polishing apparatus;
[FIG. 2] FIG. 2 is a view showing how a substrate is polished;
[FIG. 3] FIG. 3 is a graph showing a waveform indicating a change in a driving current of a table motor;
[FIG. 4] FIG. 4 is a view showing an embodiment of a flow for creating a waveform processing recipe for an operation controller;
[FIG. 5] FIG. 5 is a schematic view showing an embodiment of a model for outputting a waveform processing recipe;
[FIG. 6] FIG. 6 is a graph showing a waveform processed by adjusting waveform processing parameters; and
[FIG. 7] FIG. 7 is a view showing another embodiment of a flow for creating a waveform processing recipe for the operation controller.

**Description of Embodiments**

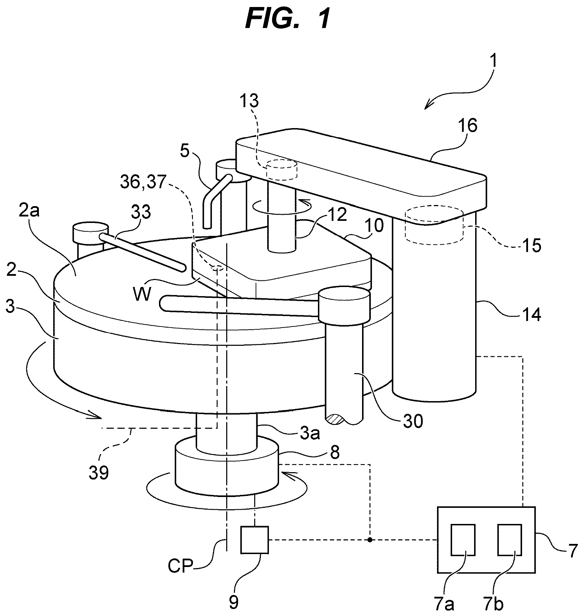

FIG. 1 is a schematic view showing one embodiment of a polishing apparatus. In the embodiment shown in FIG. 1, the polishing apparatus 1 is a polishing apparatus for polishing a rectangular substrate, but in one embodiment, the polishing apparatus 1 may be a polishing apparatus for polishing a circular substrate.

As shown in FIG. 1, the polishing apparatus 1 includes a polishing head 10 that holds and rotates a substrate W, a polishing table 3 that supports a polishing pad 2, a table motor 8 that rotates the polishing table 3, a polishing-head swing arm 16 coupled to an upper end of a support shaft 14, a polishing head shaft 12 attached to a free end of the polishing-head swing arm 16, and an operation controller 7 that controls an operation of each component of the polishing apparatus 1.

In this embodiment, the substrate W has a rectangular shape such as a printed circuit board (PCB) with an insulator or wiring on its surface, and the polishing head 10 has a rectangular shape corresponding to the shape of the substrate W. However, the shapes of the substrate W and the polishing head 10 are not limited to this embodiment. In one embodiment, the substrate W may be a circular wafer, and the polishing head 10 may have a circular shape.

The polishing head 10 is coupled to a lower end of a polishing head shaft 12, and is configured so as to be able to hold the substrate W on its lower surface by vacuum suction. The polishing head 10 presses the substrate W against the polishing surface 2a of the polishing pad 2 to polish the substrate W.

The polishing-head swing arm 16 is disposed above the polishing table 3 and is disposed parallel to the polishing surface 2a of the polishing pad 2. The polishing-head swing arm 16 is coupled to the polishing head 10 via the polishing head shaft 12, and the polishing head 10 is supported by the polishing-head swing arm 16.

The polishing apparatus 1 further includes a polishing-head rotating motor 13 coupled to the polishing head shaft 12. In this embodiment, the polishing-head rotating motor 13 is disposed inside the polishing-head swing arm 16, but in one embodiment, the polishing-head rotating motor 13 may be disposed outside the polishing-head swing arm 16.

The polishing head shaft 12 is configured to be rotatable by the polishing-head rotating motor 13. By rotating the polishing head shaft 12, the polishing head 10 is configured to rotate about the polishing head shaft 12 in a direction shown by the arrow in the figure. The polishing head shaft 12 is coupled to an elevating device (not shown). The polishing head 10 is configured to be raised and lowered via the polishing head shaft 12 by the elevating device.

The polishing apparatus 1 further includes a swing motor 15 coupled to the polishing-head swing arm 16. In this embodiment, the swing motor 15 is disposed inside the support shaft 14. The polishing-head swing arm 16 is configured to be rotatable about the support shaft 14 by the swing motor 15. The polishing head 10 is moved between a receiving position (not shown) for the substrate W and a position above the polishing table 3 by the rotation of the polishing-head swing arm 16. In one embodiment, the polishing-head swing arm 16 may be fixed to the support shaft 14, and the swing motor 15 may be coupled to the support shaft 14.

The polishing pad 2 is attached to an upper surface of the polishing table 3 and configured to rotate integrally with the polishing table 3. The polishing table 3 is coupled via a table shaft 3a to a table motor 8 disposed below it.

The polishing table 3 is configured to be rotatable around the table shaft 3a in a direction indicated by the arrow by the table motor 8. More specifically, an axis CP of the polishing table 3 and an axis of the table shaft 3a coincide with each other, and the polishing table 3 rotates around the axis CP. An example of the table motor 8 is a variable speed motor equipped with an inverter.

The polishing apparatus 1 further includes a torque measuring device 9 that measures a torque for rotating the

**EP 4 644 044 A1**

polishing table 3. The torque measuring device 9 is electrically connected to the table motor 8. During polishing of the substrate W, the polishing table 3 is driven by the table motor 8 to rotate at a constant speed. Therefore, when the torque required to rotate the polishing table 3 at the constant speed changes, a drive current of the table motor 8 changes.

The torque for rotating the polishing table 3 is a moment of a force that rotates the polishing table 3 about its axis CP. The torque for rotating the polishing table 3 corresponds to the drive current of the table motor 8. Therefore, in this embodiment, the torque measuring device 9 is a current measuring device that measures the drive current of the table motor 8.

In one embodiment, the torque measuring device 9 may be formed from at least a part of a motor driver that drives the table motor 8. In this case, the motor driver determines a current value required to rotate the polishing table 3 at a constant speed, and outputs a determined current value. The determined current value corresponds to the torque for rotating the polishing table 3. In one embodiment, the torque measuring device 9 may be a torque measuring device that directly measures the torque for rotating the polishing table 3 about its axis CP.

The polishing apparatus 1 further includes a dresser 30 for conditioning the polishing pad 2, a dressing-liquid supply nozzle 5 for supplying a dressing liquid to the polishing pad 2, and an atomizer 33 for spraying a liquid or a mixed fluid of a liquid and a gas toward the polishing pad 2. An example of the dressing liquid is pure water. The liquid sprayed from the atomizer 33 is, for example, pure water, and the gas sprayed from the atomizer 33 is, for example, nitrogen gas.

The polishing apparatus 1 includes a polishing-liquid supply path 39 for supplying a polishing liquid. The polishing-liquid supply path 39 is formed in the polishing table 3 and the table shaft 3a. More specifically, one end of the polishing-liquid supply path 39 communicates with a polishing-liquid supply hole 36 formed in the surface of the polishing table 3, and the other end is connected to a polishing-liquid supply source (not shown) via a rotary joint (not shown).

A polishing-liquid supply hole 37 is formed in the polishing pad 2 at a position corresponding to the polishing-liquid supply hole 36 of the polishing table 3. During polishing of the substrate W, the polishing liquid passes through the polishing-liquid supply path 39 and the polishing-liquid supply hole 36 and is supplied to the polishing surface 2a of the polishing pad 2 from the polishing-liquid supply hole 37. An example of the polishing liquid is a slurry containing abrasive grains. In the embodiment shown in FIG. 1, the polishing apparatus 1 has one set of polishing-liquid supply holes 36, 37, but may have multiple sets of polishing-liquid supply holes 36, 37. The polishing-liquid supply holes 36, 37 are arranged on or near the axis CP of the polishing table 3.

The operation controller 7 is composed of at least one computer, and includes a storage device 7a in which a program is stored, and a processing device 7b that executes operations according to instructions included in the program.

The processing device 7b includes a CPU (Central Processing Unit) or a GPU (Graphics Processing Unit) that executes calculations according to instructions included in the program stored in the storage device 7a. The storage device 7a includes a main storage device (e.g., random access memory) that can be accessed by the processing device 7b, and an auxiliary storage device (e.g., a hard disk drive or a solid state drive) that stores data and programs.

The elevating device (not shown), the polishing-head rotating motor 13, the swing motor 15, the table motor 8, and the torque measuring device 9 are electrically connected to the operation controller 7. The operations of the elevating device, the polishing-head rotation motor 13, the swing motor 15, the table motor 8, and the torque measuring device 9 are controlled by the operation controller 7.

In this embodiment, during polishing of the substrate W, the operation controller 7 is configured to control an output of the swing motor 15 so as to stop (i.e., the swing speed becomes zero) the swing of the polishing-head swing arm 16, but the operation controller 7 may also swing the polishing head swing arm 16 at a predetermined swing speed pattern.

The polishing head 10, the polishing-head swing arm 16, and the polishing table 3 are collectively called a polishing mechanism, and the polishing-head rotating motor 13, the swing motor 15, and the table motor 8 are collectively called a driving device for the polishing mechanism.

The substrate W is polished as follows: While rotating the polishing head 10 and rotating the polishing table 3 integrally with the polishing pad 2, the polishing liquid (slurry) is supplied onto the polishing surface 2a of the polishing pad 2 from the polishing-liquid supply hole 37. The polishing head 10 is lowered to a predetermined position (polishing height) by an elevating device (not shown).

Compressed gas is supplied to a pressure chamber (not shown) of the polishing head 10, which has been lowered to a predetermined position (polishing height), so that the polishing head 10 presses the substrate W against the polishing surface 2a of the polishing pad 2. The polishing head 10 and the polishing table 3 (and the polishing pad 2) rotate in the same direction as shown by the arrow in FIG. 1, and in this state the polishing head 10 presses the substrate W against the polishing surface 2a of the polishing pad 2.

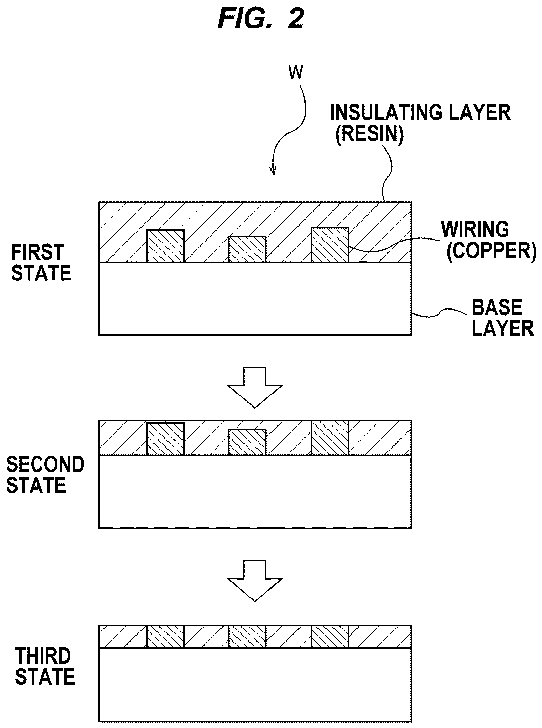

FIG. 2 is a view showing how a substrate is polished. In the embodiment shown in FIG. 2, the substrate W is a copper-clad laminate in which an insulating layer (e.g., resin) and wiring (e.g., copper) are arranged on a base layer, but the substrate W is not limited to this example. With the slurry present on the polishing surface 2a of the polishing pad 2, the substrate W is brought into sliding contact with the polishing surface 2a of the polishing pad 2. The surface (i.e., the insulating layer) of the substrate W is polished by a combination of the chemical action of the chemical components of the slurry and the mechanical action of the abrasive grains contained in the slurry.

When polishing of the substrate W is finished, the polished substrate W is removed from the polishing head 10 and transported to the next process. After polishing of the substrate W, the polishing surface 2a of the polishing pad 2 is dressed by the dresser 30. The dresser 30 slightly scrapes off the polishing pad 2 to regenerate the polishing surface 2a. The polishing head 10 holds a new substrate, and the new substrate is polished in the same manner. In this manner, polishing of substrates is repeated.

In the embodiment shown in FIG. 2, when the insulating layer of the substrate W is polished, the wiring is eventually exposed (see the second state in FIG. 2). Since the material of the wiring is different from the material of the insulating layer, a frictional force acting between the substrate W and the polishing pad 2 changes. Therefore, the operation controller 7 determines the polishing end point based on a point in time when the frictional force changes.

More specifically, the operation controller 7 determines the polishing end point of the substrate W based on a change in the output of the driving device of the polishing mechanism. In this embodiment, the torque for rotating the polishing table 3 corresponds to the driving current of the table motor 8. Therefore, the operation controller 7 determines the polishing end point of the substrate W based on a change in the driving current of the table motor 8 measured by the torque measuring device 9. In one embodiment, the torque measuring device 9 may constitute a part of the operation controller 7. In this case, the operation controller 7 measures the driving current of the table motor 8.

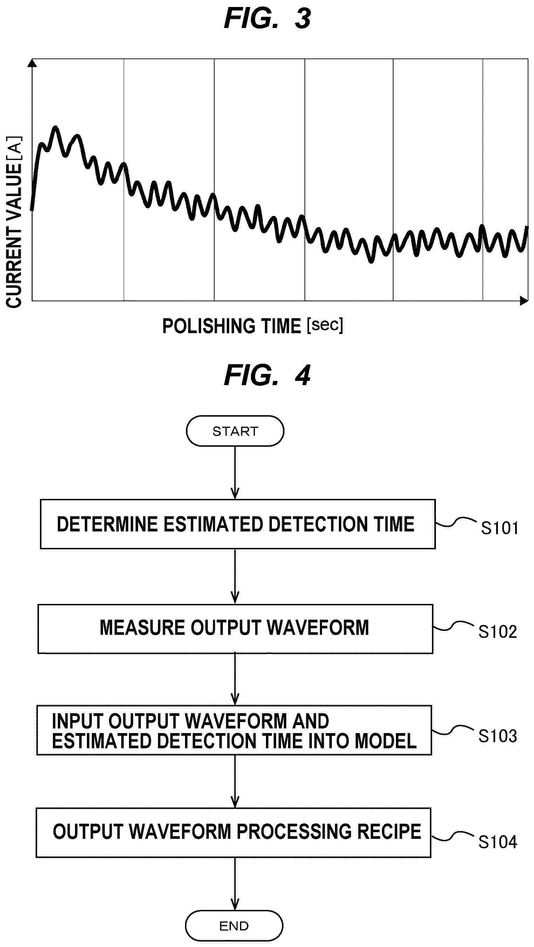

FIG. 3 is a graph showing a waveform indicating a change in the driving current of the table motor. In FIG. 3, a horizontal axis indicates a polishing time, and a vertical axis indicates a current value (average current value). As shown in FIG. 3, a waveform indicating a change in the output of the driving device (i.e., the driving current of the table motor 8) contains noise components. Therefore, it is difficult for the operation controller 7 to reliably determine the polishing end point (i.e., the change in the driving current of the table motor 8) based on the waveform containing noise components.

Therefore, in order to reliably determine the polishing end point, the operation controller 7 is configured to remove noise components by adjusting at least one type of waveform processing parameter (i.e., waveform processing condition) used in waveform processing of the output waveform. The operation controller 7 determines the polishing end point of the substrate W based on the waveform from which the noise components have been removed, and creates a waveform processing recipe.

FIG. 4 is a view showing an embodiment of a flow for creating a waveform processing recipe for the operation controller. As shown in step S101 in FIG. 4, the operation controller 7 (more specifically, the processing device 7b) determines an estimated detection time on which the polishing end point time from a start of polishing (see the first state in FIG. 2) to the polishing end point (see the third state in FIG. 2) of the substrate W is based. The estimated detection time is determined based on an initial film thickness of the substrate W to be polished and a polishing rate (the amount of polishing per unit time).

The operation controller 7 (more specifically, the processing device 7b) measures the output waveform of the driving device of the polishing mechanism (in this embodiment, the output waveform of the drive current of the table motor 8) during polishing of the substrate W (i.e., the polishing time from the start to an end of polishing of the substrate W) (see step S102). Note that the order of steps S101 and S102 is not particularly limited.

Thereafter, the operation controller 7 (more specifically, the processing device 7b) inputs the measured output waveform and the estimated detection time into a model constructed by a machine learning algorithm (see step S103), and outputs a waveform processing recipe from the model. The waveform processing recipe has waveform processing parameters for determining a simulated detection time that minimizes a difference from the estimated detection time (see step S104).

In other words, the program stored in the memory device 7a includes instructions to input the output waveform of the driving device of the polishing mechanism and the estimated detection time into the model. The estimated detection time forms a basis of the polishing end point time from the start of polishing of the substrate W to the polishing end point of the substrate W. The program includes instructions to output the waveform processing recipe from the model. The waveform processing recipe has waveform processing parameters for determining the simulated detection time that minimizes the difference from the estimated detection time.

The operation controller 7 calculates the simulated detection time by applying (and adjusting) the waveform processing parameters to the output waveform and removing noise components contained in the output waveform. For example, the operation controller 7 calculates the simulated detection time based on a peak (maximum value) detected by removing the noise components.

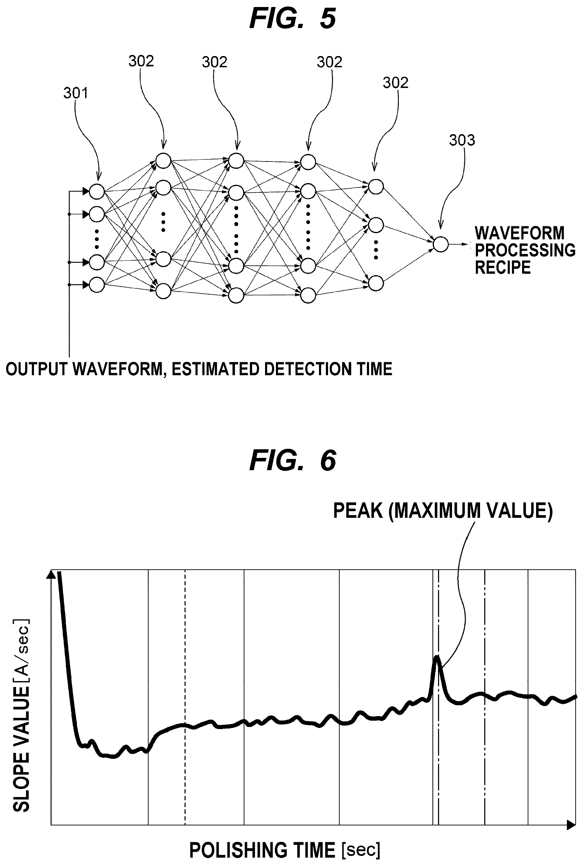

FIG. 5 is a schematic view showing an embodiment of a model for outputting a waveform processing recipe. The model is stored in the storage device 7a. The model is a neural network having an input layer 301, a plurality of hidden layers (in other words, intermediate layers) 302, and an output layer 303. The model shown in FIG. 5 has four hidden layers 302, but a configuration of the model is not limited to the embodiment shown in FIG. 5.

As shown in FIG. 5, an output waveform and an estimated detection time are input to the input layer 301 of the model. The output layer 303 of the model outputs a waveform processing recipe. When the output waveform and the estimated detection time are input to the model according to the embodiment shown in FIG. 5, a computer (i.e., the operation controller 7) executes a calculation according to an algorithm of a multilayer perceptron constituting a neural network, and the output layer 303 outputs the waveform processing recipe.

In constructing the model, an explanatory variable of the learning data is given as measured output waveforms, and a target variable of the learning data is given as values representing the deviation (difference) of the simulated detection time from the estimated detection time.

In one embodiment, the simulated detection time is calculated by comparing it to the estimated detection time according to the following formula: where "edti" represents the estimated detection time for the i-th substrate, "sdti" represents the simulated detection time for the i-th substrate, and "n" represents the number of substrates polished.

[Formula 2]

$$\sum_{i=1}^{n} (sdti - edti)^2 / n$$

FIG. 6 is a graph showing a waveform processed by adjusting the waveform processing parameters. In FIG. 6, a horizontal axis indicates the polishing time, and a vertical axis indicates the slope value.

The waveform processing parameters include parameters for identifying peaks and non-peaks included in the output waveform. Examples of the waveform processing parameters include Moving average (effective value, differential value), Averaging time (setting of the interval for obtaining the moving average of the current value), Slope Calc Span (interval for calculating the differential value for the moving average value), Slope Average (movement for the differential value), CT (Confirmation time) (time to confirm detection), and SDT (Start detection time) (setting of the start time of detection).

In the above model, the peak and the non-peak included in the output waveform are identified by applying (and adjusting) the waveform processing parameters to the input output waveform. The peak as local maximum values indicate a change (i.e., a change in the drive current of the table motor 8) in the output of the driving device of the polishing mechanism (see FIG. 6). A time point at which the output of the driving device changes corresponds to the polishing end point of the substrate W, so the polishing end point time calculated based on the peak included in the output waveform (i.e., the time from the start of polishing to the point corresponding to the peak) corresponds to the simulated detection time.

In the above model, a plurality of simulated detection times calculated by applying (and adjusting) the waveform processing parameters are compared with the estimated detection time to determine the simulated detection time with a minimum difference from the estimated detection time. The numerical value of the waveform processing parameter that minimizes the difference between the estimated detection time and the simulated detection time is the optimal value for determining the polishing end point. The waveform processing recipe has the waveform processing parameters for determining the simulated detection time with the minimum difference from the estimated detection time.

The polishing end point of the substrate W is determined based on the waveform processing recipe that has been created. Therefore, in order to accurately determine the polishing end point of the substrate W, it is necessary to create an optimal waveform processing recipe. According to the present embodiment, by outputting the waveform processing recipe from the model constructed by the machine learning algorithm, it is possible to create the waveform processing recipe that can accurately determine the polishing end point of the substrate W in a short time and without much effort. Therefore, by employing such a waveform processing recipe, it is possible to accurately determine the polishing end point of the substrate W.

In the above-described embodiment, the configuration has been described in which the waveform processing recipe is output from the model stored in the storage device 7a, but the operation controller 7 may also have a configuration in which a waveform processing recipe is automatically created without outputting the waveform processing recipe from the model constructed by the machine learning algorithm.

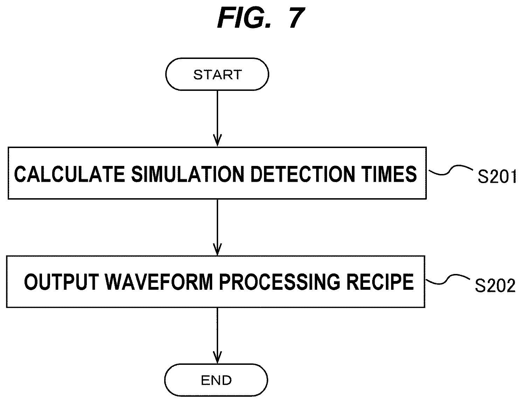

FIG. 7 is a view showing another embodiment of a flow for creating a waveform processing recipe for the operation controller. For example, the processing device 7b may apply the waveform processing parameters stored in the storage device 7a to a plurality of measured output waveforms to calculate a plurality of simulated detection times (see step S201 in FIG. 7).

Thereafter, the processing device 7b may compare the estimated detection time with a plurality of simulated detection times, and automatically create a waveform processing recipe having waveform processing parameters for determining a simulated detection time that has a minimum difference from the estimated detection time (see step S202). The simulated detection time that has a minimum difference from the estimated detection time is calculated by comparing a plurality of simulated detection times with the estimated detection time based on the above calculation formula.

In other words, the storage device 7a stores a program for causing the processing device 7b to execute a first step (see step S201) of applying the waveform processing parameters stored in the storage device 7a to a plurality of measured output waveforms to calculate a plurality of simulated detection times, and a second step (see step S202) of comparing an estimated detection time with the simulated detection times to automatically create a waveform processing recipe having waveform processing parameters for determining a simulated detection time that minimizes the difference from the estimated detection time. The program includes an instruction for causing the processing device 7b to execute the first step and the second step.

The embodiment described with reference to FIG. 4 and the embodiment described with reference to FIG. 7 may be appropriately combined as necessary. The storage device 7a stores a program that causes the processing device 7b to execute the steps shown in FIG. 4 (steps S101 to S104) and the steps shown in FIG. 7 (steps S201 and S202).

For example, the processing device 7b may execute steps S101 to S104 shown in FIG. 4 and steps S201 and S202 shown in FIG. 7. In this case, the processing device 7b may compare the waveform processing recipe created by executing the steps shown in FIG. 4 with the waveform processing recipe created by executing the steps shown in FIG. 7, and adopt an optimal waveform processing recipe depending on the substrate W to be polished.

As described above, by applying the waveform processing recipe to the output waveform of the driving device, it is possible to accurately determine the polishing end point time of the substrate W. In one embodiment, the polishing end point time may be corrected by adjusting the simulated detection time. With this configuration, it is possible to more accurately determine the polishing end point of the substrate W.

The operation controller 7 polishes a new substrate W of the same type as the substrate W, thereby acquiring polishing information data including an output value of the driving device (in this embodiment, the table motor 8) during polishing of the new substrate W. In one embodiment, the polishing information data may include not only data acquired during polishing of the new substrate W (i.e., data acquired during polishing), but also data acquired before polishing the new substrate W (data acquired before polishing).

The data acquired during polishing may include various information such as the output value of the driving device, the type of substrate W to be polished, a descending speed of the polishing head 10, a pressing force applied to the substrate W, the type, flow rate, and temperature of the polishing liquid supplied onto the polishing pad 2, etc. The data acquired before polishing may include, for example, the initial film thickness of the substrate W.

Thereafter, the operation controller 7 corrects the polishing end point time by adjusting the simulated detection time based on the polishing information data. With this configuration, the simulated detection time can be determined with higher accuracy. In this manner, the operation controller 7 is configured to execute a step of acquiring the polishing information data and a step of correcting the simulated detection time based on the polishing information data. In one embodiment, a data set corresponding to the above steps may be used to build and update the model.

In one embodiment, the operation controller 7 may correct the polishing endpoint time by adding a predetermined additional polishing time to the simulated detection time. The data set corresponding to the step of correcting the polishing end point time may be used to build and update the model. In one embodiment, the polishing end point time may correspond to the simulated detection time.

The above embodiments are described for the purpose of practicing the present invention by a person with ordinary skill in the art to which the invention pertains. Although preferred embodiments have been described in detail above, it should be understood that the present invention is not limited to the illustrated embodiments, but many changes and modifications can be made therein without departing from the appended claims.

**Industrial Applicability**

The present invention is applicable to a polishing method, a polishing apparatus, and a recording medium.

**Reference Signs List**

| | |
|---|---|
| 1 | polishing apparatus |
| 2 | polishing pad |
| 2a | polishing surface |
| 3 | polishing table |
| 3a | table shaft |
| 5 | dressing-liquid supply nozzle |
| 7 | operation controller |
| 7a | storage device |
| 7b | processing device |
| 8 | table motor |
| 9 | torque measuring device |
| 10 | polishing head |
| 12 | polishing head shaft |

13        polishing-head rotating motor
14        support shaft
15        driving motor
16        polishing-head swing arm
30        dresser
33        atomizer
36,37     polishing-liquid supply hole
39        polishing-liquid supply path
301       input layer
302       intermediate layer
303       output layer

**Claims**

1.  A polishing method comprising:

    determining an estimated detection time based on a polishing end point time from a start of polishing to a polishing end point of a substrate;
    measuring an output waveform of a driving device of a polishing mechanism during polishing of the substrate;
    inputting the measured output waveform and the estimated detection time into a model constructed by a machine learning algorithm; and
    outputting a waveform processing recipe from the model, the waveform processing recipe having waveform processing parameters for determining a simulated detection time that minimizes a difference from the estimated detection time.

2.  The polishing method according to claim 1, wherein the simulated detection time is calculated by comparing it with the estimated detection time based on the following formula:

    [Formula 1]

    $$\sum_{i=1}^{n}(sdti - edti)^2/n$$

    where, edti: estimated detection time for the i-th substrate
    sdti: simulated detection time for the i-th substrate
    n: number of polished substrates.

3.  The polishing method according to claim 1, comprising:

    acquiring polishing information data including an output value of the driving device by polishing a new substrate of the same type as the substrate; and
    correcting the polishing end point time by adjusting the simulated detection time based on the polishing information data.

4.  The polishing method according to claim 1, comprising correcting the polishing end point time by adding a predetermined additional polishing time to the simulated detection time.

5.  The polishing method according to claim 1, wherein the simulated detection time is calculated by applying at least one of the waveform processing parameters used for waveform processing of the output waveform to the measured output waveform.

6.  The polishing method according to claim 5, wherein the waveform processing parameters include a parameter for identifying peaks and non-peaks included in the output waveform.

7.  The polishing method according to claim 1, in constructing the model, an explanatory variable of a learning data is given as the measured output waveform, and a target variable of the learning data is given as a numerical value representing a deviation of a simulated detection time calculated by removing a noise component contained in the output waveform from the estimated detection time.

8. A polishing apparatus comprising:

a polishing table configured to support a polishing pad;
a polishing head configured to press a substrate against a polishing surface of the polishing pad to polish the substrate;
a polishing-head swing arm coupled to the polishing head; and
a computer having a storage device and a processing device, and
wherein the processing device is configured to:

apply waveform processing parameters stored in the storage device to a plurality of output waveforms of a driving device being at least one of the polishing table, the polishing head, and the polishing-head swing arm, measured during polishing of the substrate, to calculate a plurality of simulated detection times; and
compare an estimated detection time based on a polishing end point time from a start of polishing to a polishing end point of the substrate with the simulated detection times to create a waveform processing recipe having waveform processing parameters for determining a simulated detection time that minimizes a difference from the estimated detection time.

9. The polishing apparatus according to claim 8, wherein the processing device is configured to correct the polishing end point time by adjusting the simulated detection time based on polishing information data including an output value of the driving device, the polishing information data being acquired by polishing a new substrate of the same type as the substrate.

10. The polishing apparatus according to claim 8, wherein the processing device is configured to correct the polishing end point time by adding a predetermined additional polishing time to the simulated detection time.

11. The polishing apparatus according to claim 8, wherein the storage device stores a model constructed by a machine learning algorithm, and
wherein the processing device is configured to:

input the output waveform of the driving device and the estimated detection time into the model; and
execute a calculation to output a waveform processing recipe from the model, the waveform processing recipe having waveform processing parameters for determining a simulated detection time that minimizes a difference from the estimated detection time.

12. A computer-readable recording medium storing a program that causes a computer to execute:

a step of calculating a plurality of simulated detection times by applying waveform processing parameters to a plurality of output waveforms of a driving device of a polishing mechanism measured during polishing of a substrate; and
a step of creating a waveform processing recipe having waveform processing parameters for determining a simulated detection time that minimizes a difference from an estimated detection time, by comparing the estimated detection time based on a polishing end point time from a start of polishing to a polishing end point of the substrate, with the simulated detection times.

13. The recording medium according to claim 12, wherein the program causes the computer to execute:

a step of inputting the output waveform of the driving device and the estimated detection time into an input layer of a model consisting of a neural network having the input layer, a plurality of intermediate layers, and an output layer; and
a step of outputting a waveform processing recipe from the output layer, the waveform processing recipe having waveform processing parameters for determining a simulated detection time that minimizes a difference from the estimated detection time by executing calculations according to an algorithm of a multilayer perceptron constituting the neural network.

# FIG. 1

# *FIG. 2*

W

INSULATING LAYER
(RESIN)

FIRST
STATE

WIRING
(COPPER)

BASE
LAYER

SECOND
STATE

THIRD
STATE

## FIG. 3

## FIG. 4

START

↓

DETERMINE ESTIMATED DETECTION TIME    S101

↓

MEASURE OUTPUT WAVEFORM    S102

↓

INPUT OUTPUT WAVEFORM AND
ESTIMATED DETECTION TIME INTO MODEL    S103

↓

OUTPUT WAVEFORM PROCESSING RECIPE    S104

↓

END

## FIG. 5

OUTPUT WAVEFORM, ESTIMATED DETECTION TIME

WAVEFORM PROCESSING RECIPE

## FIG. 6

PEAK (MAXIMUM VALUE)

SLOPE VALUE[A/sec]

POLISHING TIME [sec]

## FIG. 7

```
        ┌─────────────┐
        │    START    │
        └──────┬──────┘
               │
               ▼
┌──────────────────────────────────────┐
│  CALCULATE SIMULATION DETECTION TIMES │ ～ S201
└──────────────────┬───────────────────┘
                   │
                   ▼
┌──────────────────────────────────────┐
│   OUTPUT WAVEFORM PROCESSING RECIPE   │ ～ S202
└──────────────────┬───────────────────┘
                   │
                   ▼
            ┌─────────────┐
            │     END     │
            └─────────────┘
```

## INTERNATIONAL SEARCH REPORT

| International application No. |
|---|
| **PCT/JP2023/043096** |

**A. CLASSIFICATION OF SUBJECT MATTER**

**_B24B 37/013_**(2012.01)i; **_B24B 49/10_**(2006.01)i; **_G05B 23/02_**(2006.01)i; **_H01L 21/304_**(2006.01)i
FI: B24B37/013; H01L21/304 622R; H01L21/304 622S; B24B49/10; G05B23/02 P

According to International Patent Classification (IPC) or to both national classification and IPC

**B. FIELDS SEARCHED**

Minimum documentation searched (classification system followed by classification symbols)

B24B37/013; B24B49/10; G05B23/02; H01L21/304

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2020/235581 A1 (EBARA CORPORATION) 26 November 2020 (2020-11-26) paragraphs [0029]-[0110], fig. 1-18 | 1-13 |
| A | JP 2018-61002 A (EBARA CORPORATION) 12 April 2018 (2018-04-12) paragraphs [0116]-[0147], fig. 1-18 | 1-13 |
| A | JP 2007-331108 A (EBARA CORPORATION) 27 December 2007 (2007-12-27) paragraphs [0071]-[0072], fig. 9 | 1-13 |
| A | JP 2009-28856 A (TOKYO SEIMITSU CO., LTD.) 12 February 2009 (2009-02-12) | 1-13 |

☐ Further documents are listed in the continuation of Box C.    ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" document member of the same patent family |
| "P" | document published prior to the international filing date but later than the priority date claimed | |

| Date of the actual completion of the international search | Date of mailing of the international search report |
|---|---|
| **30 January 2024** | **13 February 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

## INTERNATIONAL SEARCH REPORT
### Information on patent family members

International application No.

**PCT/JP2023/043096**

| Patent document cited in search report | | | Publication date (day/month/year) | Patent family member(s) | | | Publication date (day/month/year) |
|---|---|---|---|---|---|---|---|
| WO | 2020/235581 | A1 | 26 November 2020 | US | 2022/0234164 | A1 | |
| | | | | paragraphs [0047]-[0146], fig. 1-18 | | | |
| | | | | CN | 113853275 | A | |
| | | | | KR | 10-2022-0011144 | A | |
| JP | 2018-61002 | A | 12 April 2018 | US | 2018/0093360 | A1 | |
| | | | | paragraphs [0172]-[0207], fig. 1-18 | | | |
| | | | | CN | 107877356 | A | |
| | | | | KR | 10-2018-0036545 | A | |
| JP | 2007-331108 | A | 27 December 2007 | (Family: none) | | | |
| JP | 2009-28856 | A | 12 February 2009 | US | 2008/0071414 | A1 | |

Form PCT/ISA/210 (patent family annex) (July 2022)

**EP 4 644 044 A1**

**Patent documents cited in the description**

- JP 2021065990 A